# EUROPÄISCHE PATENTSCHRIFT

(11) **EP 1 489 669 B1**
(45) Veröffentlichungstag und Bekanntmachung des Hinweises auf die Patenterteilung: **12.04.2006**
(21) Anmeldenummer: 04009489.8
(22) Anmeldetag: 22.04.2004
(51) Int. Cl.: H01L 41/24, H01L 41/083, F02M 51/06

(54) **Verfahren zum Vorbehandeln eines elektromechanischen Wandlers, sowie Vorrichtung zum Durchführen des Verfahrens**
Method for initialising an electro-mechanical converter, and device for carrying out such method
Procédé de prétraitement d'un convertisseur électromécanique et dispositif pour la mise en oeuvre du procédé

(30) Priorität: 18.06.2003 DE 10327410
(43) Veröffentlichungstag der Anmeldung: 22.12.2004
(73) Patentinhaber: ROBERT BOSCH GMBH, 70442 Stuttgart (DE)
(72) Erfinder: Liskow, Uwe, 71679 Asperg (DE)

(56) Entgegenhaltungen:
- WO-A-03/065468
- DE-A- 10 028 335
- DE-A- 19 756 182
- DE-A- 19 946 718

## Beschreibung

### Stand der Technik

Die Erfindung betrifft zunächst ein Verfahren zum Vorbehandeln eines elektromechanischen Wandlers, insbesondere zum Polen eines piezoelektrischen Stellglieds einer Einspritzanlage einer Brennkraftmaschine, bei dem an den Wandler vor dem eigentlichen Betrieb ein bestimmtes Vorbehandlungssignal angelegt wird, und bei dem während des Anliegens des Vorbehandlungssignals wenigstens zeitweise eine mechanische Last auf den Wandler einwirkt.

Ferner betrifft die Erfindung eine Vorrichtung zum Vorbehandeln eines elektromechanischen Wandlers, insbesondere zum Polen eines piezoelektrischen Stellglieds einer Einspritzanlage einer Brennkraftmaschine, mit einer Aufnahme für mindestens einen elektromechanischen Wandler, mit einer Einrichtung zum Anlegen eines bestimmten elektrischen Vorbehandlungssignals an den Wandler und mit einer Einrichtung zum Aufbringen einer mechanischen Last auf den Wandler.

Ein Verfahren der eingangs genannten Art ist aus der DE 199 46 718 C2 bekannt. Es wird bei elektromechanischen Wandlern in Form von piezoelektrischen Stellgliedern verwendet. Derartige piezoelektrische Stellglieder wiederum kommen in Injektoren von Einspritzanlagen zum Einsatz, um beispielsweise ein Ventilelement von einer geschlossenen in eine geöffnete Position und wieder zurück zu bewegen. Das bekannte piezoelektrische Stellglied weist ein piezoelektrisches Substrat auf, in dem eine Vielzahl räumlich verteilt angeordneter Domänen vorhanden sind, die zumindest teilweise unterschiedlich ausgerichtet sind.

Damit das piezoelektrische Stellglied bestimmte gewünschte Eigenschaften im späteren Betrieb aufweist, wird bei dem bekannten Verfahren an das piezoelektrische Stellglied vor dessen eigentlichen Einsatz eine elektrische Spannung angelegt, welche im Wesentlichen der elektrischen Spannung während des späteren normalen Betriebs des piezoelektrischen Stellglieds entspricht. Ferner wird das piezoelektrische Stellglied bei der Ansteuerung mit dem Vorbehandlungssignal mechanisch belastet, wobei diese mechanische Belastung im Wesentlichen der mechanischen Belastung während des normalen Betriebs entspricht.

Insbesondere beim Einsatz von elektromechanischen Wandlern in Kraftstoff-Einspritzvorrichtungen ist ein möglichst großes Hubvermögen, also ein großer Maximalhub bei einer bestimmten Ladung, gewünscht. Außerdem soll der elektromechanische Wandler eine möglichst hohe Lebensdauer aufweisen. Es ist daher die Aufgabe der vorliegenden Erfindung, ein Verfahren der eingangs genannten Art so weiterzubilden, dass der entsprechend vorbehandelte elektromechanische Wandler die genannten Eigenschaften aufweist. Die Erfindung hat ferner die Aufgabe, eine entsprechende Vorrichtung und einen entsprechenden elektromechanischen Wandler bereitzustellen.

Diese Aufgabe wird bei einem Verfahren der eingangs genannten Art dadurch gelöst, dass sich die mechanische Last während der Vorbehandlung in vorgegebener Weise ändert.

Bei einer Vorrichtung der eingangs genannten Art wird die Aufgabe dadurch gelöst, dass sie eine Steuer- und/oder Regeleinheit umfasst, welche mit den beiden Einrichtungen derart verbunden ist, dass ein bestimmter Verlauf des elektrischen Vorbehandlungssignals und ein bestimmter Verlauf der mechanischen Last realisiert werden können.

Bei einem elektromechanischen Wandler wird die Aufgabe dadurch gelöst, dass er gemäß einem Verfahren der obigen Art vorbehandelt ist.

### Vorteile der Erfindung

Bei dem erfindungsgemäßen Verfahren wird die mechanische Last während der Vorbehandlung nicht konstant gehalten. Sie wird stattdessen in vorgegebener Art und Weise variiert. Dabei haben zu jedem Zeitpunkt während der Durchführung des Vorbehandlungsverfahrens das elektrische Vorbehandlungssignal und die mechanische Last bestimmte gewünschte Werte, es liegen also "Wertpaare" aus der Last und dem elektrischen Vorbehandlungssignal vor.

Es hat sich gezeigt, dass das erfindungsgemäße Vorbehandlungsverfahren für den elektromechanischen Wandler besonders schonend ist. Insbesondere wurde festgestellt, dass während der Durchführung des erfindungsgemäßen Vorbehandlungsverfahrens am elektromechanischen Wandler nur wenige oder überhaupt keine Risse entstehen. Dies führt gegenüber herkömmlichen Vorbehandlungsverfahren zu einer Verlängerung der Lebensdauer des elektromechanischen Wandlers. Ferner kann das Hubvermögen entsprechend der Art und Weise, in der sich die mechanische Last während der Vorbehandlung ändert, so beeinflusst werden, dass es optimal den Anforderungen im späteren Normalbetrieb entspricht.

Die gleichen Vorteile ergeben sich bei der Verwendung der erfindungsgemäßen Vorrichtung. Der Einsatz des erfindungsgemäßen elektromechanischen Wandlers ist insgesamt kostengünstig, da dieser eine lange Lebensdauer aufweist. Darüber hinaus weist eine Brennkraftmaschine, in deren Einspritzsystem ein solcher elektromechanischer Wandler eingesetzt ist, ein gutes Emissions- und Verbrauchsverhalten auf.

Vorteilhafte Weiterbildungen der Erfindung sind in Unteransprüchen angegeben.

Zunächst wird vorgeschlagen, dass die mechanische Last einer bestimmten Kraft und/oder einem bestimmten Hub entspricht. Ein bestimmter Kraftverlauf während der Vorbehandlung kann technisch einfach eingestellt werden und wirkt sich besonders günstig im Hinblick auf die Lebensdauer des elektromechanischen Wandlers aus. Ein bestimmter Hubverlauf wiederum ermöglicht eine sehr exakte Beeinflussung des Hubvermögens. Optimal ist es, wenn eine bestimmte Kraft-Hub-Kombination vorgegeben wird, denn hierdurch können gleichzeitig das Hubvermögen und die Lebensdauer des elektromechanischen Wandlers optimal beeinflusst werden.

Ferner wird vorgeschlagen, dass die mechanische Last der Wirkung des elektrischen Vorbehandlungssignals auf den elektrochemischen Wandler entgegenwirkt. Wird also durch das elektrische Vorbehandlungssignal eine Verkürzung des elektromechanischen Wandlers bewirkt, wirkt bei dieser Weiterbildung die mechanische Last in Zugrichtung, wird dagegen durch das elektrische Vorbehandlungssignal eine Verlängerung beziehungsweise Ausdehnung des elektromechanischen Wandlers bewirkt, wirkt die mechanische Last in Druckrichtung. Vor allem der letztgenannten Fall ist für die Vermeidung von Rissen in dem elektromechanischen Wandler optimal. Dessen Lebensdauer ist daher besonders lang.

Eine weitere vorteilhafte Ausgestaltung des erfindungsgemäßen Verfahrens sieht vor, dass durch das elektrische Vorbehandlungssignal die Ladung des Wandlers verändert wird, und dass der Verlauf der mechanischen Last im Wesentlichen gleichsinnig zum Verlauf der Ladung des Wandlers ist. Dies bedeutet, dass eine Erhöhung der Ladung des Wandlers auch zu einer Erhöhung der mechanischen Last führt, wobei der Umfang der Erhöhung nicht gleich sein muss und im Verlauf der Durchführung des Verfahrens variieren kann.

In konkreter Weiterbildung dieses Verfahrens wird vorgeschlagen, dass die Ladung des Wandlers im Wesentlichen linear ansteigt bis zu einem Maximum und dann wieder im Wesentlichen linear abfällt, und dass die mechanische Last ebenfalls im Wesentlichen linear ansteigt bis zu einem Maximum und dann wieder im Wesentlichen linear abfällt. Dabei ist es optimal, wenn die Minima und die Maxima der einzelnen Verläufe gleichzeitig auftreten. Dieses Verfahren ist technisch sehr einfach zu realisieren.

Alternativ hierzu wird vorgeschlagen, dass durch das elektrische Vorbehandlungssignal die Ladung des Wandlers verändert wird, und dass der Verlauf der mechanischen Last im Wesentlichen gegensinnig zum Verlauf der Ladung des Wandlers ist. In diesem Fall kann der elektromechanische Wandler mit zunehmender Veränderung der Ladung seine Länge besonders gut ändern. Er erreicht daher sein maximales Hubvermögen besonders schnell, und das maximale Hubvermögen ist besonders groß. Dieses Verfahren ist besonders dann von Vorteil, wenn die Veränderung der Ladung derart ist, dass eine Ausdehnung des elektromechanischen Wandlers bewirkt wird, wobei in diesem Falle zur Rissvermeidung darauf zu achten ist, dass während der Durchführung des Vorbehandlungsverfahrens im elektromechanischen Wandler keine Zugspannungen auftreten. Der Gradient der Veränderung der mechanischen Last sowie das Minimum der mechanischen Last sind entsprechend abzustimmen.

In konkreter Ausgestaltung hierzu wird vorgeschlagen, dass die Ladung des Wandlers im Wesentlichen linear ansteigt bis zu einem Maximum und dann wieder im Wesentlichen linear abfällt, und dass die mechanische Last im Wesentlichen linear abfällt bis zu einem Minimum und dann wieder im Wesentlichen linear ansteigt. Dieses Verfahren ist technisch ebenfalls leicht realisierbar.

### Zeichnungen

Nachfolgend werden besonders bevorzugte Ausführungsbeispiele der vorliegenden Erfindung unter Bezugsnahme auf die beiliegende Zeichnung näher erläutert. In der Zeichnung zeigen:
- Figur 1: eine schematische Darstellung einer Kraftstoff-Einspritzvorrichtung mit einem elektromechanischen Wandler;
- Figur 2: eine schematische Darstellung einer Vorrichtung zur Vorbehandlung des elektromechanischen Wandlers von Figur 1;
- Figur 3: ein Diagramm, in dem der Ladezustand des elektromechanischen Wandlers von Figur 1 über der Zeit während der Durchführung einer Vorbehandlung aufgetragen ist;
- Figur 4: ein Diagramm, in dem die Verläufe eines Hubs und einer Kraft über der Zeit aufgetragen sind, die in der Vorrichtung von Figur 2 während eines ersten Vorbehandlungsverfahrens erfasst werden;
- Figur 5: ein Diagramm ähnlich Figur 4 bei einem zweiten Vorbehandlungsverfahren; und
- Figur 6: ein Diagramm ähnlich Figur 4 eines dritten Vorbehandlungsverfahrens.

### Beschreibung der Ausführungsbeispiele

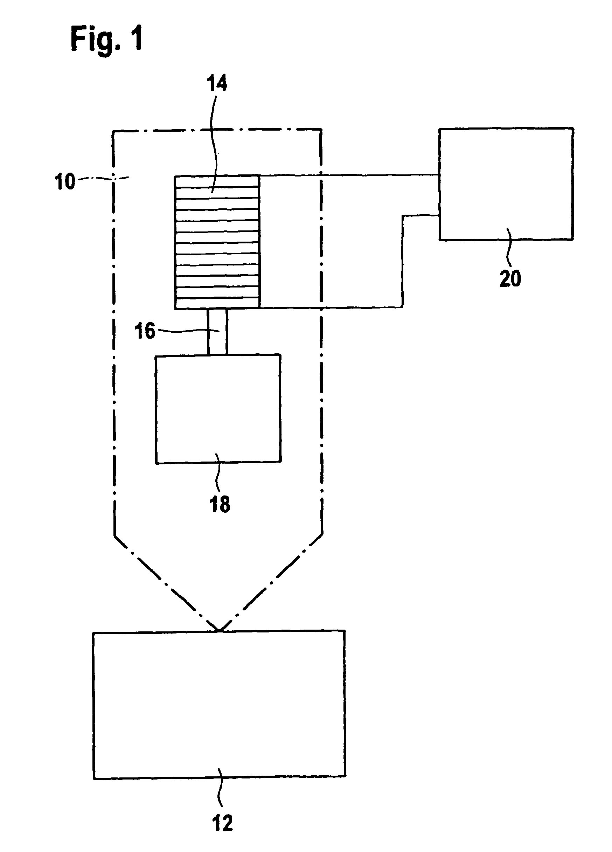

In Figur 1 trägt eine Kraftstoff-Einspritzvorrichtung insgesamt das Bezugszeichen 10. Sie ist nur schematisch strichpunktiert dargestellt und kommt in einer Brennkraftmaschine (nicht dargestellt) zum Einsatz, und sie dient zur Einspritzung von Kraftstoff in einen Brennraum 12. Die Kraftstoff-Einspritzvorrichtung 10 umfasst einen elektromechanischen Wandler 14, der vorliegend als Piezoaktor ausgeführt ist. Dieser ist über eine nicht näher dargestellte Kopplungseinrichtung 16 mit einem nur symbolisch dargestellten Ventilelement 18 verbunden.

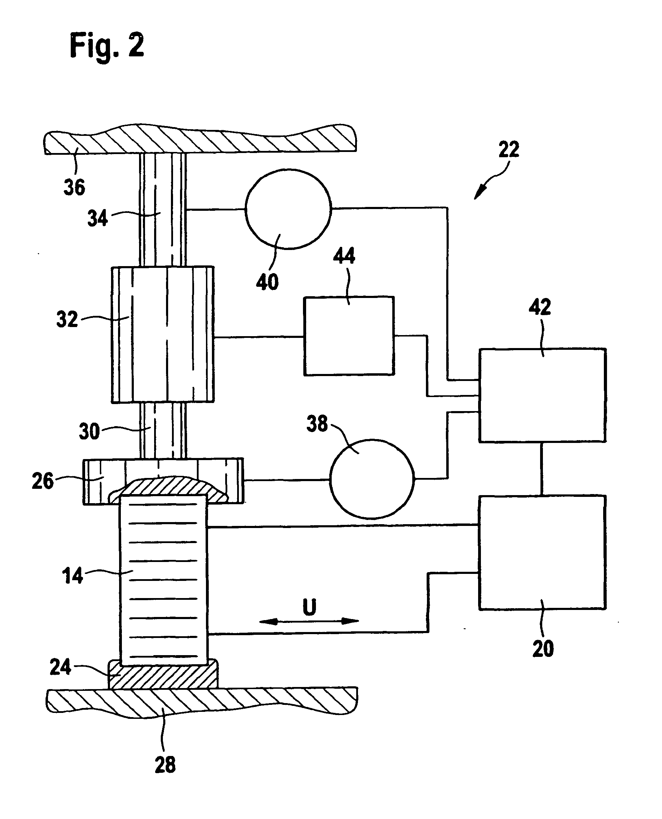

Der Piezoaktor 14 ist an eine Ansteuerschaltung 20 angeschlossen, mit der durch Anlegen einer Spannung U eine Ladung des Piezoaktors 14 verändert werden kann. Eine Erhöhung der Ladung des Piezoaktors 14 resultiert in einer Ausdehnung, eine Verringerung der Ladung in einer Verkürzung des Piezoaktors 14. Damit die Länge des Piezoaktors 14 während des Einsatzes in der Kraftstoff-Einspritzvorrichtung 10 in der gewünschten Art und Weise geändert werden kann, wird der Piezoaktor 14 vor dem Einbau in die Kraftstoff-Einspritzvorrichtung 10 einer Vorbehandlung unterzogen. Diese Vorbehandlung wird in einer speziellen Vorrichtung 22 durchgeführt, die in Figur 2 dargestellt ist:

Die Vorrichtung 22 umfasst eine untere Aufnahme 24 und eine obere Aufnahme 26 für den Piezoaktor 14. Die untere Aufnahme 24 ist starr mit einem Tisch 28 verbunden. Die obere Aufnahme 26 ist dagegen am Ende eines Kolbens 30 eines Hydraulikzylinders 32 befestigt (möglich ist aber auch der Einsatz von pneumatischen oder elektrischen Stellgliedern). Dieser ist wiederum über ein Befestigungsteil 34 an einem als starr anzusehenden Träger 36 gehalten. Eine Bewegung der oberen Aufnahme 26 wird von einem Wegsensor 38 erfasst, wohingegen eine Reaktionskraft von einer Kraftmesseinrichtung 40 am Befestigungsteil 34 abgegriffen wird.

Der Wegsensor 38 und die Kraftmesseinrichtung 40 liefern entsprechende Signale an eine Steuer- und Regeleinrichtung 42. Diese steuert wiederum eine Hydraulikeinheit 44 an, mit der der Hydraulikzylinder 32 betätigt wird- Insofern bilden die beiden Sensoren 38 und 40 zusammen mit der Steuer- und Regeleinrichtung 42 und der Hydraulikeinheit 44 mit dem Hydraulikzylinder 32 einen geschlossenen Regelkreis. Die Steuer- und Regeleinrichtung 42 steuert auch die Ansteuerschaltung 20 an, mit der die Ladung des Piezoaktors 14 beeinflusst wird.

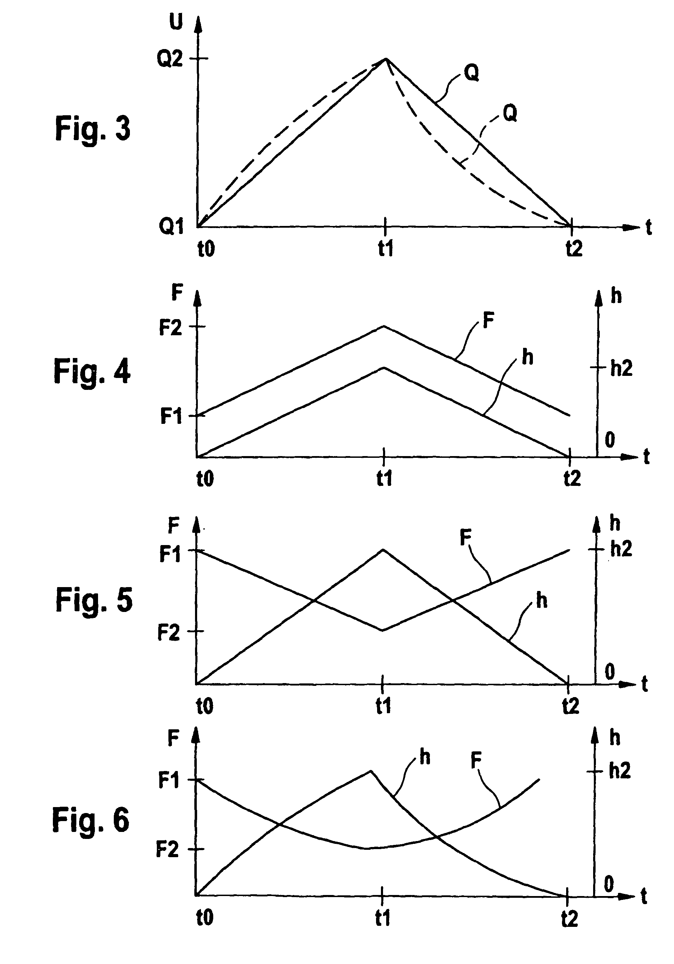

Wie aus Figur 3 ersichtlich ist, steuert die Steuer- und Regeleinrichtung 42 die Ansteuerschaltung 20 so an, dass sich eine Ladung Q des Piezoaktors 14 linear von einem Ausgangswert Q1 bis auf ein Maximum Q2 erhöht und dann wieder auf den Ausgangswert Q1 abfällt. Dieser Vorgang wird quasistatisch, also vergleichsweise langsam, durchgeführt, und er bewirkt eine Polarisierung des Piezoaktors 14. Eine solche ist für den späteren Normalbetrieb des Piezoaktors 14 erforderlich.

Bei einer ersten Verfahrensart, die in Figur 4 dargestellt ist, wird angenommen, dass das Befestigungsteil 34 eine vergleichsweise steife Feder mit einer Federsteifigkeit c umfasst. Ferner wird angenommen, dass die Hydraulikeinheit 44 so angesteuert wird, dass zu Verfahrensbeginn (Zeitpunkt t0) eine statische Anfangskraft F1 auf den Piezoaktor 14 wirkt. Bei dieser Anfangskraft F1 handelt es sich um eine Druckkraft. Schließlich wird bei dieser ersten Verfahrensart davon ausgegangen, dass nach der Einstellung der Anfangskraft F1 der Kolben 30 gegenüber dem Hydraulikzylinder 32 verriegelt wird.

Wird nun entsprechend Figur 3 die Ladung des Piezoaktors 14 linear erhöht und so dessen Länge vergrößert, wird von der Kraftmesseinrichtung 40 ein dem Anstieg der Ladung Q entsprechender und daher weitgehend linearer Kraftanstieg von der Kraft F1 bis zu einer Maximalkraft F2 erfasst. Diese Maximalkraft F2 wird zum gleichen Zeitpunkt t1 erreicht, zu dem die Ladung Q ihr Maximum Q2 erreicht.
Gleichzeitig wird vom Wegsensor 38 ein entsprechender Hub h erfasst, der zum Zeitpunkt t1 einen Maximalwert h2 erreicht. Am Ende des Vorbehandlungsverfahrens (Zeitpunkt t2) ist die Ladung des Piezoaktors 14 wieder auf einen Wert Q1 abgefallen, und der Hub h liegt wieder bei im Wesentlichen Null.

Da die Kraft F sich im Wesentlichen allein aus dem Hub h und der Steifigkeit c der Feder im Befestigungsteil 34 ergibt, gemäß der Formel dF = c x dh, wird am Ende der Vorbehandlung des Piezoaktors 14 von der Kraftmesseinrichtung 40 wieder die ursprüngliche Einspannkraft F1 gemessen. Diese erste Verfahrensart ist technisch besonders einfach zu realisieren, wobei die mechanische Last, die auf den Piezoaktor 14 während der Durchführung des Vorbehandlungsverfahrens einwirkt, in Form der Parameter Hub h und Kraft F variabel ist.

Ein anderes Vorbehandlungsverfahren, welches ebenfalls in der in Figur 2 gezeigten Vorbehandlungsvorrichtung 22 durchgeführt werden kann, und bei dem von einem starren Befestigungsteil 34 ausgegangen wird, wird nun unter Bezugsnahme auf Figur 5 erläutert:

Nach dem Einbau des Piezoaktors 14 in die beiden Aufnahmen 24 und 26 wird die Hydraulikeinheit 44 von der Steuer- und Regeleinrichtung 42 so angesteuert, dass auf den Piezoaktor 14 eine anfängliche Druckkraft F1 wirkt. Dies ist der Ausgangszustand zum Zeitpunkt t0. Nun wird die Ansteuerschaltung 20 von der Steuer- und Regeleinrichtung 42 so angesteuert, dass die Ladung des Piezoaktors 14 vom Wert Q1 bis auf den Wert Q2 ansteigt, entsprechend Figur 3, was zu einer Ausdehnung des Piezoaktors 14 führt. Gleichzeitig wird die Hydraulikeinheit 44 von der Steuer- und Regeleinrichtung 42 so angesteuert, dass die von der Kraftmesseinrichtung 40 erfasste Druckkraft, welche auf den Piezoaktor 14 wirkt, linear von der Anfangskraft F1 bis auf ein Minimum F2 abfällt. Das Minimum F2 wird zum gleichen Zeitpunkt t1 erreicht, zu dem die Ladung Q ihr Maximum Q2 erreicht.

Vom Wegsensor 38 wird ein entsprechender Hub h erfasst, dessen Maximalwert h2 größer ist als der Maximalwert h2, welcher bei der vorhergehenden Verfahrensart (Figur 4) erzielt wurde, da die auf den Piezoaktor 14 wirkende Kraft F2 zum Zeitpunkt t1, also bei maximaler Ladung Q des Piezoaktors 14, niedriger ist als bei dem in Figur 4 gezeigten Verfahren. Bei dieser Verfahrensart kann sich der Piezoaktor 14 also besonders gut dehnen. Dies kann zu einer Verkürzung des Vorbehandlungsverfahrens oder zur Erzielung eines höheren Hubvermögens bei dem Piezoaktor 14 genutzt werden. Wenn die Ladung Q vom Maximalwert Q2 wieder auf den Ausgangswert Q1 zurückgeführt wird, wird die Hydraulikeinheit 44 von der Steuer- und Regeleinrichtung 42 so angesteuert, dass die Kraft wieder auf den Ausgangswert F1 ansteigt. Entsprechend verringert sich der Hub h wieder auf den Ausgangswert Null.

Bei der im Zusammenhang mit Figur 5 erläuterten Verfahrensart wurde der Hydraulikzylinder 32 kraftgeregelt. Denkbar ist jedoch ebenso eine Wegregelung entsprechend dem Signal des Wegsensors 38. Möglich ist aber auch, dass eine bestimmte Kraft-Hub-Kombination vorgegeben wird und entsprechend dieser Vorgabe eine bestimmte Ladung Q am Piezoaktor 14 eingestellt wird. Ein entsprechender Verlauf der Ladung Q ist in Figur 3 gestrichelt gezeigt, und die entsprechenden Kurven für die Kraft F und den Hub h sind in Figur 6 über der Zeit aufgetragen. Mit der Vorbehandlungsvorrichtung 22 können somit ganz unterschiedliche Vorbehandlungsverfahren an einem Piezoaktor 14 realisiert werden. Um im Hinblick auf die Lebensdauer des Piezoaktors 14 optimale Ergebnisse zu erzielen, ist jedoch vor allem bei den beiden Verfahrensarten gemäß 5 und 6 darauf zu achten, dass im Piezoaktor 14 keine Zugspannungen während der Durchführung des Verfahrens auftreten. Der Minimalwert F2 muss also immer einer Druckkraft entsprechen.

## Patentansprüche

1. Verfahren zum Vorbehandeln eines elektromechanischen Wandlers (14), insbesondere zum Polen eines piezoelektrischen Stellglieds einer Einspritzanlage einer Brennkraftmaschine, bei dem an den Wandler (14) vor dem eigentlichen Betrieb ein bestimmtes elektrisches Vorbehandlungssignal (U) angelegt wird, und bei dem während des Anliegens des elektrischen Vorbehandlungssignals (U) wenigstens zeitweise eine mechanische Last (F, h) auf den Wandler (14) einwirkt, **dadurch gekennzeichnet, dass** sich die mechanische Last (F, h) während der Vorbehandlung in vorgegebener Weise ändert.

2. Verfahren nach Anspruch 1, **dadurch gekennzeichnet, dass** die mechanische Last einer bestimmten Kraft (F) und/oder einem bestimmten Hub (h) entspricht.

3. Verfahren nach einem der Ansprüche 1 oder 2, **dadurch gekennzeichnet, dass** die mechanische Last (F, h) der Wirkung (Q) des elektrische Vorbehandlungssignal (U) auf den elektromechanischen Wandler (14) entgegenwirkt.

4. Verfahren nach einem der Ansprüche 1 bis 3, **dadurch gekennzeichnet, dass** durch das elektrische Vorbehandlungssignal (U) die Ladung (Q) des Wandlers (14) verändert wird, und dass der Verlauf der mechanischen Last (F, h) im Wesentlichen gleichsinnig zum Verlauf der Ladung (Q) des Wandlers (14) ist.

5. Verfahren nach Anspruch 4, **dadurch gekennzeichnet, dass** die Ladung (Q) des Wandlers (14) im Wesentlichen linear ansteigt bis zu einem Maximum (Q2) und dann wieder im Wesentlichen linear abfällt, und dass die mechanische Last (F, h) ebenfalls im Wesentlichen linear ansteigt bis zu einem Maximum (F2, h2) und dann wieder im Wesentlichen linear abfällt.

6. Verfahren nach einem der Ansprüche 1 bis 3, **dadurch gekennzeichnet, dass** durch das elektrische Vorbehandlungssignal (U) die Ladung (Q) des Wandlers (14) verändert wird, und dass der Verlauf der mechanischen Last (F, h) im Wesentlichen gegensinnig zum Verlauf der Ladung (Q) des Wandlers (14) ist.

7. Verfahren nach Anspruch 6, **dadurch gekennzeichnet, dass** die Ladung (Q) des Wandlers (14) im Wesentlichen linear ansteigt bis zu einem Maximum (Q2) und dann wieder im Wesentlichen linear abfällt, und dass die mechanische Last (F, h) im Wesentlichen linear abfällt bis zu einem Minimum (F2, h2) und dann wieder im Wesentlichen linear ansteigt.

8. Vorrichtung (22) zum Vorbehandeln eines elektromechanischen Wandlers (14), insbesondere zum Polen eines piezoelektrischen Stellglieds einer Einspritzanlage einer Brennkraftmaschine, mit einer Aufnahme (24, 26) für mindestens einen elektromechanischen Wandler (14), mit einer Einrichtung (20) zum Anlegen eines bestimmten elektrischen Vorbehandlungssignals (U) an den Wandler (14), und mit einer Einrichtung (32, 44) zum Aufbringen einer mechanischen Last (F, h) auf den Wandler (14), **dadurch gekennzeichnet, dass** sie eine Steuer- und/oder Regeleinheit (42) umfasst, welche mit den beiden Einrichtungen (20, 32, 44) derart verbunden ist, dass ein bestimmter Verlauf des elektrischen Vorbehandlungssignals (U) und ein bestimmter Verlauf der mechanischen Last (F, h) realisiert werden können.

9. Vorrichtung (22) nach Anspruch 8, **dadurch gekennzeichnet, dass** sie zur Durchführung des Verfahrens nach einem der Ansprüche 1 bis 7 geeignet ist.

## Revendications

1. Procédé de prétraitement d'un convertisseur électromécanique (14), en particulier pour polariser un organe de réglage piézo-électrique d'un système d'injection d'un moteur à combustion interne, selon lequel un signal de prétraitement électrique (U) déterminé est appliqué au convertisseur (14) avant le fonctionnement proprement dit, et pendant la présence du signal de prétraitement électrique (U) une charge mécanique (F, h) agit au moins temporairement sur le convertisseur (14),
**caractérisé en ce que**
la charge mécanique (F, h) varie pendant le prétraitement d'une manière prédéterminée.

2. Procédé selon la revendication 1,
**caractérisé en ce que**
la charge mécanique correspond à une force (F) déterminée et/ou à une course (h) déterminée.

3. Procédé selon l'une quelconque des revendications 1 ou 2,
**caractérisé en ce que**
la charge mécanique (F, h) agit à l'encontre de l'effet (Q) du signal de prétraitement électrique (U) sur le convertisseur électromécanique (14).

4. Procédé selon l'une quelconque des revendications 1 à 3,
**caractérisé en ce que**
la charge (Q) du convertisseur (14) est modifiée par le signal de prétraitement électrique (U), et l'évolution de la charge mécanique (F, h) est pour l'essentiel dans le même sens que l'évolution de la charge (Q) du convertisseur (14).

5. Procédé selon la revendication 4,
**caractérisé en ce que**
la charge (Q) du convertisseur (14) augmente pour l'essentiel de manière linéaire jusqu'à un maximum (Q2) puis redescend pour l'essentiel de manière linéaire, et la charge mécanique (F, h) augmente également de manière linéaire jusqu'à un maximum (F2, h2) puis redescend pour l'essentiel de manière linéaire.

6. Procédé selon l'une quelconque des revendications 1 à 3,
**caractérisé en ce que**
la charge (Q) du convertisseur (14) est modifiée par le signal de prétraitement électrique (U), et l'évolution de la charge mécanique (F, h) est pour l'essentiel opposée à l'évolution de la charge (Q) du convertisseur (14).

7. Procédé selon la revendication 6,
**caractérisé en ce que**
la charge (Q) du convertisseur (14) augmente pour l'essentiel de manière linéaire jusqu'à un maximum (Q2) puis redescend pour l'essentiel de manière linéaire, et la charge mécanique (F, h) descend pour l'essentiel de manière linéaire jusqu'à un minimum (F2, h2) puis augmente à nouveau pour l'essentiel de manière linéaire.

8. Dispositif (22) de prétraitement d'un convertisseur électromécanique (14), en particulier pour polariser un organe de réglage piézo-électrique d'un système d'injection d'un moteur à combustion interne, comprenant un logement (24, 26) pour au moins un convertisseur électromécanique (14), une installation (20) pour appliquer un signal de prétraitement électrique (U) au convertisseur (14), et une installation (32, 44) pour appliquer une charge mécanique (F, h) sur le convertisseur (14),
**caractérisé en ce qu'**
il comprend une unité de commande et/ou de régulation (42) reliée aux deux installations (20, 32, 44) pour permettre de réaliser une évolution déterminée du signal de prétraitement électrique (U) et une évolution déterminée de la charge mécanique (F, h).

9. Dispositif (22) selon la revendication 8,
**caractérisé en ce qu'**
il est approprié pour la mise en oeuvre du procédé selon l'une quelconque des revendications 1 à 7.

## Claims

1. Method for pretreating an electro-mechanical converter (14), in particular for polarizing a piezoelectric actuator element of an injection system of an internal combustion engine, in which a specific electrical pretreatment signal (U) is applied to the converter (14) before the actual operation, and in which a mechanical load (F, h) acts on the converter (14) at least temporarily during the application of the electric pretreatment signal (U), **characterized in that** the mechanical load (F, h) changes in a predefined fashion during the pretreatment.

2. Method according to Claim 1, **characterized in that** the mechanical load corresponds to a specific force (F) and/or a specific stroke (h).

3. Method according to one of Claims 1 or 2, **characterized in that** the mechanical load (F, h) counteracts the effect (Q) of the electrical pretreatment signal (U) on the electromechanical converter (14).

4. Method according to one of Claims 1 to 3, **characterized in that** the charge (Q) of the converter (14) is changed by the electric pretreatment signal (U), and **in that** the profile of the mechanical load (F, h) is essentially in the same direction as the profile of the charge (Q) of the converter (14).

5. Method according to Claim 4, **characterized in that** the charge (Q) of the converter (14) rises essentially linearly up to a maximum (Q2) and then drops essentially linearly again, and **in that** the mechanical load (F, h) also rises essentially linearly up to a maximum (F2, h2) and then drops again essentially linearly.

6. Method according to one of Claims 1 to 3, **characterized in that** the charge (Q) of the converter (14) is changed by the electric pretreatment signal (U), and **in that** the profile of the mechanical load (F, h) is essentially in the opposite direction to the profile of the charge (Q) of the converter (14).

7. Method according to Claim 6, **characterized in that** the charge (Q) of the converter (14) rises essentially linearly up to a maximum (Q2) and then drops again essentially linearly, and **in that** the mechanical load (F, h) drops essentially linearly to a minimum value (F2, h2) and then drops again essentially linearly.

8. Device (22) for pretreating an electromechanical converter (14), in particular for polarizing a piezoelectric actuator element of an injection system of an internal combustion engine, having a receptacle (24, 26) for at least one electromechanical converter (14), having a device (20) for applying a specific electric pretreatment signal (U) to the converter (14), and having a device (32, 44) for applying a mechanical load (F, h) to the converter (14), **characterized in that** it comprises an open-loop and/or closed-loop control unit (42) which is connected to the two devices (20, 32, 44) in such a way that a specific profile of the electric pretreatment signal (U) and a specific profile of the mechanical load (F, h) can be implemented.

9. Device (22) according to Claim 8, **characterized in that** it is suitable for carrying out the method according to one of Claims 1 to 7.
